# EUROPEAN PATENT APPLICATION

(11) **EP 4 412 404 A2**
(43) Date of publication of application: **07.08.2024**
(21) Application number: 23212690.4
(22) Date of filing: 28.11.2023
(51) Int. Cl.: H05K 1/02, H05K 1/18, H01R 13/6594

(54) **SHIELD CAN AS STIFFENER ON FLEXIBLE PRINTED CIRCUITS**

(30) Priority: 04.01.2023 US 202318149919
(71) Applicant: Meta Platforms Technologies, LLC, Menlo Park, CA 94025 (US)
(72) Inventor: HOWSER, Jason, Menlo Park (US); MILROY, Maxwell, Menlo Park (US); WEBER, Adam, Menlo Park (US)
(74) Representative: Murgitroyd & Company

(57) **Abstract**

Aspects of the present disclosure are directed to a flexible printed circuit board (FPC) assembly including an FPC, an electrical connector mounted on a first surface of the FPC and configured to transfer data and power signals, and a shield can mounted on a second surface of the FPC. The electrical connector can be a USB-C connector. The second surface of the FPC can be opposite the first surface of the FPC. The shield can can surround an area on the second surface of the FPC that overlaps an area of the first surface of the FPC on which the electrical connector is mounted. Electromagnetic discharge (ESD) protection components can be mounted on the FPC within the shield can. The shield can can be configured as a strain-relief to stiffen the FPC, and can electromagnetically shield the ESD protection components.

## Description

### TECHNICAL FIELD

The present disclosure is directed to a flexible printed circuit board (FPC) assembly including a shield can stiffener mounted on the FPC.

### BACKGROUND

Demand for miniaturization of electronics has increased. The flexible printed circuit board, also known as a flexible printed circuit (FPC), has become an increasingly popular component for facilitating miniaturization of electronic devices such as mobile telephones, tablets, and portable gaming devices. Since an FPC can be bent in one or more places in an electronic device to enable a desired arrangement of components and/or can flex due to movement of components connected to the FPC, it is important that the FPC has a robust construction that resists damage due to bending and flexing.

Stiffening plates are critical to the construction of robust FPCs. A stiffening plate is made of a rigid material having a rigidity greater than that of the FPC substrate. A stiffening plate attached to an FPC creates a strain relief and prevents solder joints on the FPC from breaking when the FPC bends and flexes. Stiffening plates are particularly important for regions interfacing with connectors, which can have numerous signal pins that are soldered to the FPC and are critical to the FPC's functions.

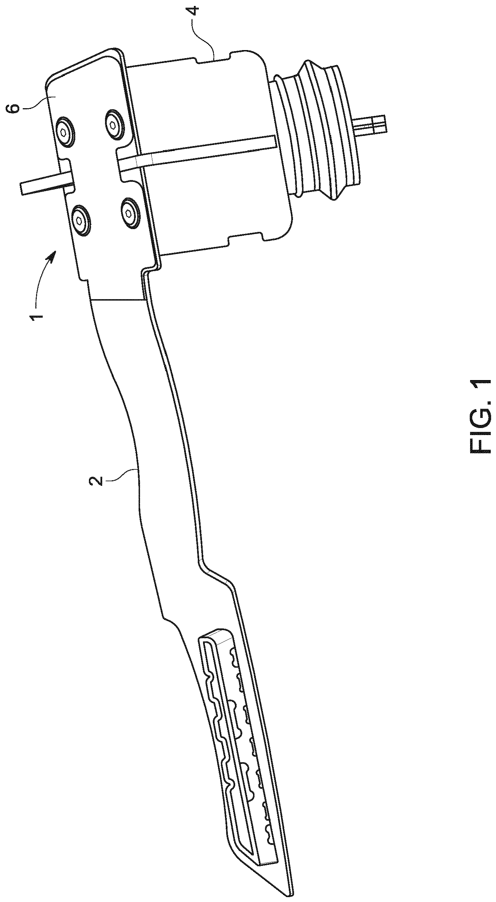

Figure 1 illustrates a conventional FPC assembly 1. As shown in Figure 1, the FPC assembly 1 includes an FPC 2, a USB-C connector 4 mounted on a first surface (connector-side surface) of the FPC 2, and a stiffening plate 6 mounted on a second surface of the FPC 2, behind the USB-C connector 4. The stiffening plate 6 provides a strain relief area on the FPC 2. However, conventional stiffening plates, such as the stiffening plate 6, decrease the usable surface area of the second surface of the FPC, because components cannot be mounted on the FPC in the area in which the stiffening plate is located.

### SUMMARY OF THE INVENTION

Aspects of the present disclosure are directed to a flexible printed circuit board (FPC) assembly including an FPC, an electrical connector mounted on the FPC and configured to transfer data and power signals, and a shield can mounted on the FPC in alignment with the electrical connector. In some embodiments, the electrical connector can be a USB-C connector. The electrical connector can be mounted on a first side of the FPC, and can include a plurality of electrical connection components that are electrically connected to the FPC.

The electrical connection components can include a plurality of signal pins and a plurality of ground pins. The plurality of ground pins can be disposed in a perimeter path surrounding the plurality of signal pins. In some embodiments, some of the ground pins can be surface-mounted on the first side of FPC, and some of the ground pins can be through-hole mounted in the FPC such that they extend through a second surface of the FPC opposite the first surface of the FPC, to securely mount the electrical connector to the FPC.

The shield can can be mounted on the second surface of the FPC in alignment with electrical connector. The shield can can stiffen the FPC and function as a strain-relief. In some embodiments, the shield can can overlap an entire area occupied by the electrical connection elements of the electrical connector that are mounted on the FPC, to prevent solder joints of the electrical connection elements from breaking when the FPC bends and flexes.

Additionally, the shield can can electromagnetically shield electrical components of the FPC assembly. In some embodiments, electrostatic discharge (ESD) protection components can be mounted on the second surface of the FPC at locations overlapping the electrical connector, and the shield can can cover the ESD protection components to electromagnetically shield the ESD protection components.

In accordance with a first aspect of the present disclosure, there is provided a flexible printed circuit board (FPC) assembly comprising: an FPC having a front surface and a rear surface; a USB-C connector mounted on the front surface of a first portion of the FPC, wherein the USB-C connector has a plurality of electrical connection elements extending from an end of the USB-C connector and electrically connected to the FPC; one or more electrostatic discharge (ESD) protection components mounted on the rear surface of a second portion of the FPC, wherein the first portion, with the front surface on which the USB-C connector is mounted, overlaps with the second portion, with the rear surface on which the one or more electrostatic discharge (ESD) protection components are mounted; and a shield can mounted on the rear surface of the FPC and covering at least some of the one or more ESD components.

In some embodiments, the plurality of electrical connection elements can include: a plurality of signal pins; and a plurality of grounding components surrounding the plurality of signal pins. The rear surface of a portion of the FPC covered by the shield can can overlap with an entirety of the front surface of a portion of the FPC occupied by the plurality of electrical connection elements.

In some embodiments, the plurality of grounding components can include: through-hole mounted ground pins arranged in a first and second columns outside of the signal pins, the through-hole mounted ground pins extending from the front surface of the FPC through the rear surface of the FPC; and surface-mounted ground pins arranged in first and second rows extending between the first and second columns, the surface-mounted ground pins being surface mounted on the front surface of the FPC. The plurality of signal pins can be disposed between the first and second columns and between the first and second rows.

In some embodiments, the plurality of electrical connection elements can further include power pins disposed outside of the plurality of grounding components.

In some embodiments, the power pins can be configured to be connected to contact charging components.

In some embodiments, the USB-C connector can further include alignment pins through-hole mounted in the FPC at positions outside of the plurality of grounding components so as to extend from the front surface of the FPC and through the rear surface of the FPC. Sidewalls of the shield can can include cut-out portions accommodating the alignment pins.

In some embodiments, sidewalls of the shield can can include cut-out portions and a back wall of the shield can can include apertures.

In accordance with a second aspect of the present disclosure, there is provided a flexible printed circuit board (FPC) assembly comprising: an FPC having a first surface and a second surface opposite the first surface; an electrical connector mounted on the first surface of a connector mounting portion of the FPC and configured to transfer data and power signals; and a shield can mounted on the second surface of a shield can mounting portion of the FPC. The shield can mounting portion, with the second surface on which the shield can is mounted, can overlap with the connector mounting portion, with the first surface on which the electrical connector is mounted.

In some embodiments, the FPC assembly can further include one or more electrostatic discharge (ESD) protection components mounted on the second surface of the shield can mounting portion. The shield can can cover the one or more ESD protection components.

In some embodiments, the electrical connector can include: a plurality of signal pins electrically connected to the FPC on the first surface of the connector mounting portion; and a plurality of grounding components disposed around the plurality of signal pins and electrically connected to the FPC on the first surface of the connector mounting portion. The shield can mounting portion, with the second surface on which the shield can is mounted, can overlap with an entirety of the connector mounting portion, with the first surface on which the plurality of signal pins and the plurality of grounding components are mounted.

In some embodiments, the plurality of grounding components can be disposed in a perimeter path on the first surface of the connector mounting portion, wherein the perimeter path surrounds the plurality of signal pins. The plurality of grounding components can include: a first ground pin disposed at a first corner position on the perimeter path; a second ground pin disposed at a second corner position on the perimeter path; a third ground pin disposed at a third corner position on the perimeter path; a fourth ground pin disposed at a fourth corner position on the perimeter path; a first group of ground fence pins disposed on the perimeter path at locations between the first and second ground pins; a second group of ground fence pins disposed on the perimeter path at locations between the third and fourth ground pins; a fifth ground pin disposed on the perimeter path between the first and third ground pins; and a sixth ground pin disposed on the perimeter path between the second and fourth ground pins.

In some embodiments, the first, second, third, fourth, fifth, and sixth ground pins can be through-hole solder-mounted so as to extend from the first surface of the FPC to the second surface of the FPC.

In some embodiments, the electrical connector can further include power pins mounted on the first surface of the connector mounting portion, outside of the plurality of grounding components. The shield can mounting portion, with the second surface on which the shield can is mounted, can overlap with an entirety of the connector mounting portion, with the first surface on which the plurality of signal pins, the plurality of grounding components, and the power pins are mounted.

In some embodiments, the electrical connector can further include alignment pins through-hole mounted in the FPC at positions outside of the plurality of grounding components so as to extend from the first surface of the FPC and through the second surface of the FPC. Sidewalls of the shield can can include cut-out portions accommodating the alignment pins.

In accordance with a third aspect of the present disclosure, there is provided a flexible printed circuit board (FPC) assembly comprising: an FPC having a front surface and a rear surface; a USB-C connector mounted on the front surface of a first portion of the FPC, wherein the USB-C connector has a plurality of electrical connection elements extending from an end of the USB-C connector and electrically connected to the FPC; and a shield can mounted on the rear surface of a second portion of the FPC in alignment with the first portion, with the front surface on which the USB-C connector is mounted. The shield can can be configured as a strain-relief.

In some embodiments, the FPC assembly can further include at least one electrostatic discharge (ESD) diode mounted on the rear surface of the second portion of the FPC. The shield can can cover the ESD diode.

In some embodiments, the electrical connection elements can include: a plurality of signal pins disposed on the front surface of the first portion; and a plurality of grounding components disposed in a perimeter path on the front surface of the first portion, the perimeter path surrounding the plurality of signal pins. The second portion, with the rear surface on which the shield can is mounted, can overlap with an entirety of the first portion, with the front surface on which the plurality of signal pins and the plurality of grounding components are mounted.

In some embodiments, the plurality of grounding components can include grounding pins that are mounted in through holes in the FPC.

In some embodiments, the electrical connection elements can further include power pins of a contact charging assembly.

In some embodiments, a distance between adjacent grounding components among the grounding components can be less than λ × 10, wherein λ is a wavelength of signals transmitted and received by a device in which the FPC assembly is installed.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

### BRIEF DESCRIPTION OF THE DRAWINGS

Figure 1 is a perspective view of a conventional flexible printed circuit board (FPC) assembly.
Figure 2 is a perspective view illustrating an FPC assembly, according to an embodiment.
Figure 3 is a partial left side perspective view of the FPC assembly of Figure 2.
Figure 4 is a partial right side perspective view of the FPC assembly of Figure 2.
Figure 5 is a partial rear view of the FPC assembly of Figure 2.
Figure 6 is a partial rear perspective view showing components on a rear end of a USB-C connector of the FPC assembly of Figure 2.
Figure 7 is a partial left side view of the FPC assembly of Figure 2.
Figure 8 is a partial rear perspective view of the FPC assembly of Figure 2, and shows components on a front surface and a rear surface of an FPC of the FPC assembly.
Figure 9 is a partial rear view of the FPC assembly of Figure 2, and shows the components on the front surface and the rear surface of the FPC.
Figure 10 is a partial rear view of the FPC assembly of Figure 2 showing the components on the rear surface of the FPC.

The features and aspects introduced here may be better understood by referring to the following Detailed Description in conjunction with the accompanying drawings, in which like reference numerals indicate identical or functionally similar elements. The drawings may not be to scale, and the relative size, proportions, and depiction of elements in the drawings may be exaggerated for clarity, illustration, and convenience.

### DETAILED DESCRIPTION

Several embodiments are discussed below in more detail in reference to the figures.

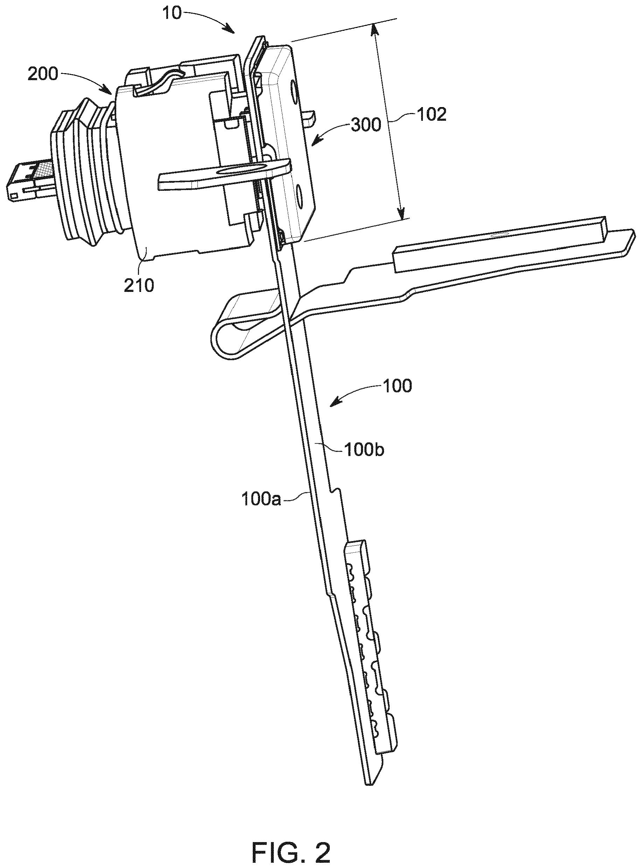

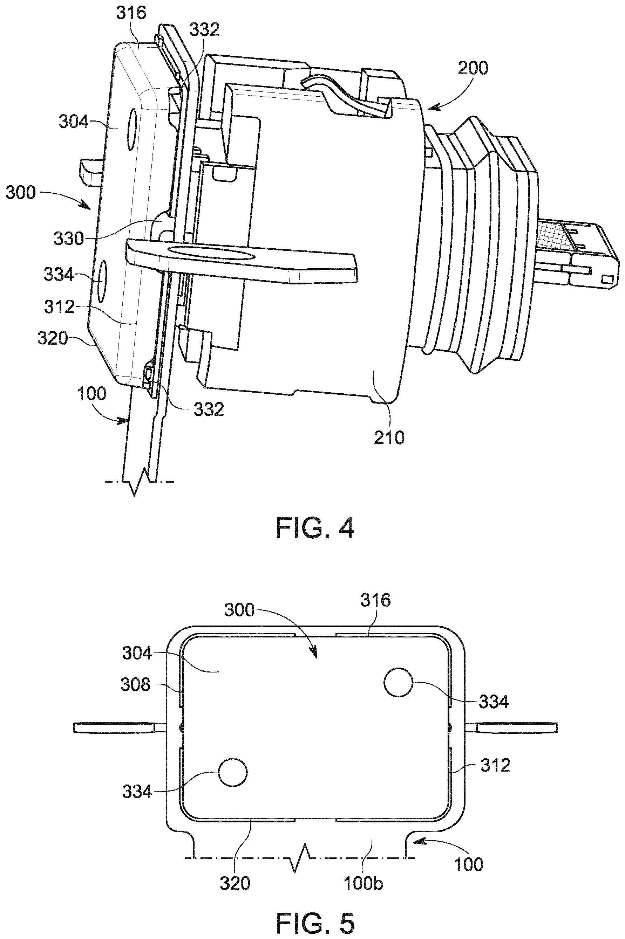

Figures 2 to 5 illustrate a FPC assembly 10, according to an embodiment. The FPC assembly 10 includes an FPC 100 having a front surface 100a (connector-side surface) and a rear surface (shield-side surface) 100b, a USB-C connector 200 mounted on the FPC 100, and a shield can 300 mounted on the FPC 100 opposite the shield can 200. Although the disclosure herein specifically describes embodiments the FPC assembly 10 including the USB-C connector 200, it is to be understood that the USB-C connector 200 is merely an example of an electrical connector that can be provided to transfer data and/or power to and from the FPC 100. Therefore, in additional embodiments, other types of electrical connectors capable of transferring data and/or power to and from the FPC 100 can be included in the FPC assembly 10 instead of the USB-C connector 200.

The USB-C connector 200 can be mounted on the front surface 100a of the FPC 100 in a connector mounting portion 102 of the FPC 100. The shield can 300 can be mounted on the rear surface 100b of the FPC 100 in the connector mounting portion 102 of the FPC 100. For example, as will be described later in more detail, the shield can 300 can be aligned with the USB-C connector 200 to surround an area on the rear surface 100b of the FPC 100 that overlaps signal pins, ground pins, and other components of the USB-C connector 200 that are electrically connected to/mounted on the FPC 100.

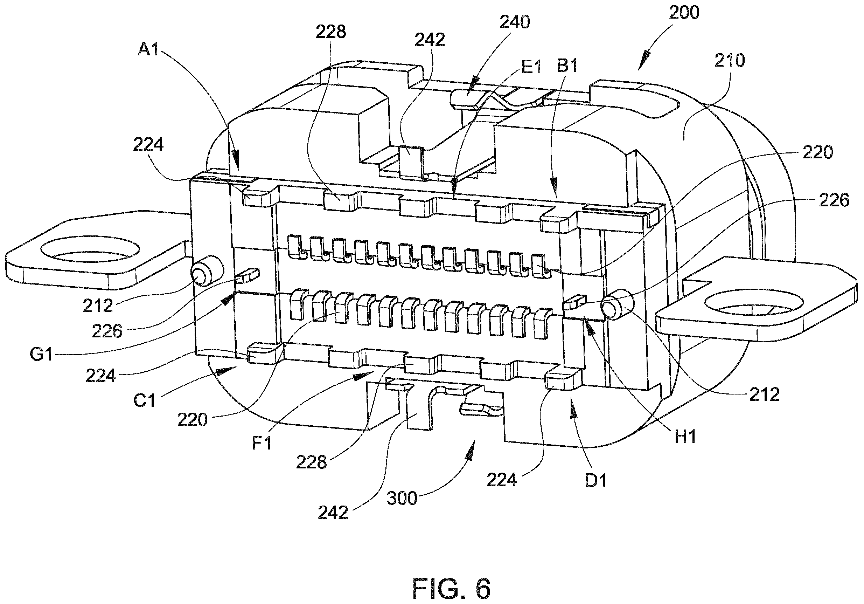

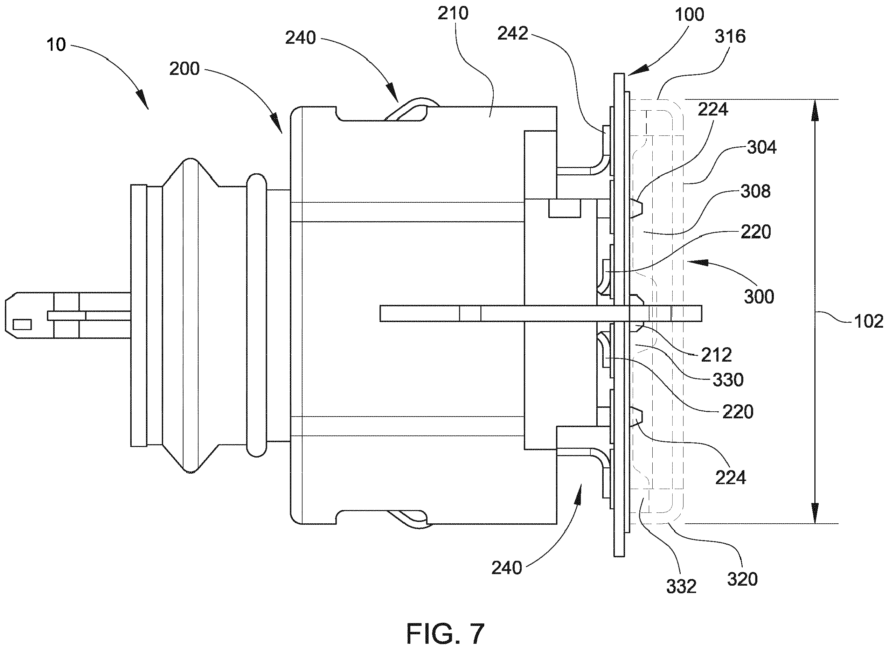

The USB-C connector 200 will now be described in more detail, with reference to Figures 6 and 7. Figure 6 is a partial rear perspective view showing components on a rear end of the USB-C connector 200. Figure 7 is a partial left side view of the FPC assembly 10.

Referring to Figures 6 and 7, the USB-C connector 200 includes a connector body 210 housing electronic components for data and power transfer. The USB-C connector includes a plurality of electrical connection elements extending from the connector body 210 at the rear end of the USB-C connector 200.

The plurality of electrical connection elements can include, for example, a plurality of signal pins 220 and a plurality of grounding components surrounding the signal pins 220. The grounding components can include, for example, a plurality of first ground pins 224, a pair of second ground pins 226, and a plurality of ground fence pins 228. The USB-C connector 200 can also include power terminals 240 power pins 242. The signal pins 220, the first ground pins 224, the second ground pins 226, the ground fence pins 228, and the power pins 242 extend from the connector body 210 at the rear end of the USB-C connector 200.

The signal pins 220 and the ground fence pins 228 can be configured as surface-mount pins that are solder-mounted on the front surface 100a of the FPC 100. It is important to electrically shield the signal pins 220 on the front surface 100a of the FPC 100. Therefore, as will be described later in more detail, the ground fence pins 228 are provided to electrically shield the signal pins 120.

For example, the first ground pins 224 and the second ground pins 224 can be DIP pins. The first ground pins 224 and the second ground pins 226 can be configured as through-mount pins that are solder-mounted to the FPC 100 to securely mount the USB-C connector 200 to the FPC 100 in conjunction with the alignment pins 212, as will be described later in more detail. In some embodiments, a diameter or thickness dimensions of the first ground pins 224 can be greater than the diameter or thickness dimensions of the second ground pins 226, since the first ground pins 224 are positioned at locations that are more critical for securing the USB-C connector 200 on the FPC 100 to prevent tilting and twisting of the USB-C connector 200 with respect to the FPC 100.

Referring to Figure 6, the signal pins 220 can be arranged in an array in central region of the rear end of the USB-C connector 200. The first ground pins 224, the second ground pins 226, and the ground fence pins 228 can be disposed to surround the signal pins 220. For example, the first ground pins 224, the second ground pins 226, and the ground fence pins 228 can be arranged along a perimeter path surrounding the array of signal pins 220. For example, the first ground pins 224, the second ground pins 226, and the ground fence pins 228 can be arranged along a rectangular perimeter path surrounding the array of signal pins 220.

As shown in Figure 6, in some embodiments, the first ground pins 224 can be disposed at corner positions A1, B1, C1, and D1, respectively, on a rectangular perimeter path surrounding the array of signal pins 220. One group of the ground fence pins 228 can be disposed outside of (above) the array of signal pins 220, and can disposed in-line at positions E1 between the first ground pins 224 at the corner positions A1 and B1, along the rectangular perimeter path surrounding the array of signal pins 220. Another group of the ground fence pins 228 can be disposed outside of (below) the array of signal pins 220, and can disposed in-line at positions F1 between the first ground pins 224 at the corner positions C1 and D1, along the rectangular perimeter path surrounding the array of signal pins 220. One of the second ground pins 226 can be disposed laterally outside of the array of signal pins 220, and can be disposed at position G1 between the first ground pins 224 at the corner positions A1 and C1. Another one of the second ground pins 226 can be disposed laterally outside of the array of signal pins 220, and can be disposed at position H1 between the first ground pins 224 at the corner positions B1 and D1.

Thus, the first and second ground pins 224 and 226 are arranged in a first column from position A1 to position C1 and a second column from position B1 to position D1, and the ground fence pins 228 are arranged in first row between the first and second columns and a second row between the first and second columns. The signal pins 220 are disposed between the first and second columns and the first and second rows.

As shown in Figures 6 and 7, the power terminals 240 can be disposed at top and bottom portions of the connector body 210. In some embodiments, the power terminals 240 can be connected to contact charging components providing contact charging functionality to an electronic device in which the FPC assembly 10 is installed. The power pins 242 of the power terminals 240 can be respectively disposed outside of (above) the group of ground fence pins 228 at positions E1 and outside of (below) the group of ground fence pins 228 at positions F1. The power pins 242 can be configured as surface-mount pins that are solder-mounted on the front surface 100a of the FPC 100.

In some embodiments, alignment pins 212 can be disposed at the rear end of the connector 200 for securing the USB-C connector 200 to the FPC 100, as will be described in more detail later. The alignment pins 212 can be integrally formed with connector body 210 and can be made of plastic, for example.

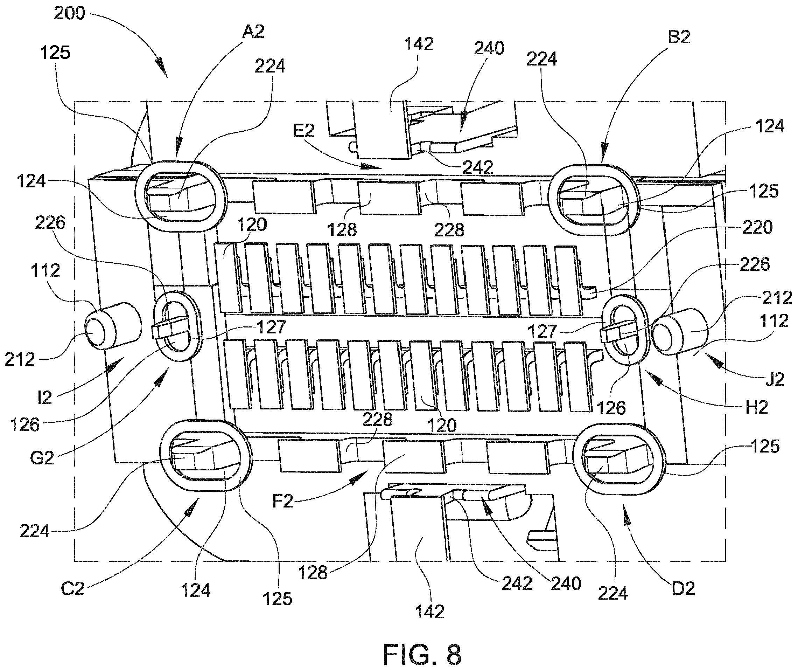

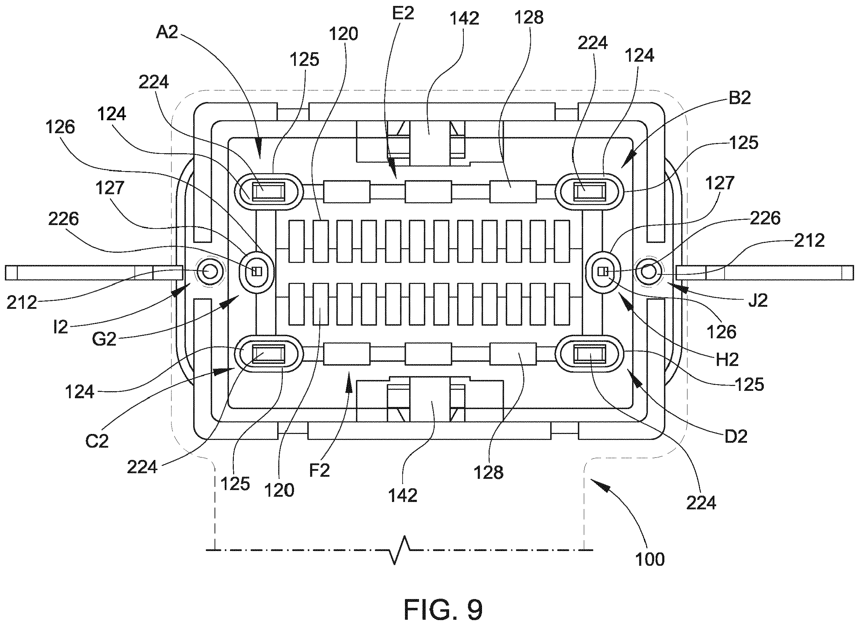

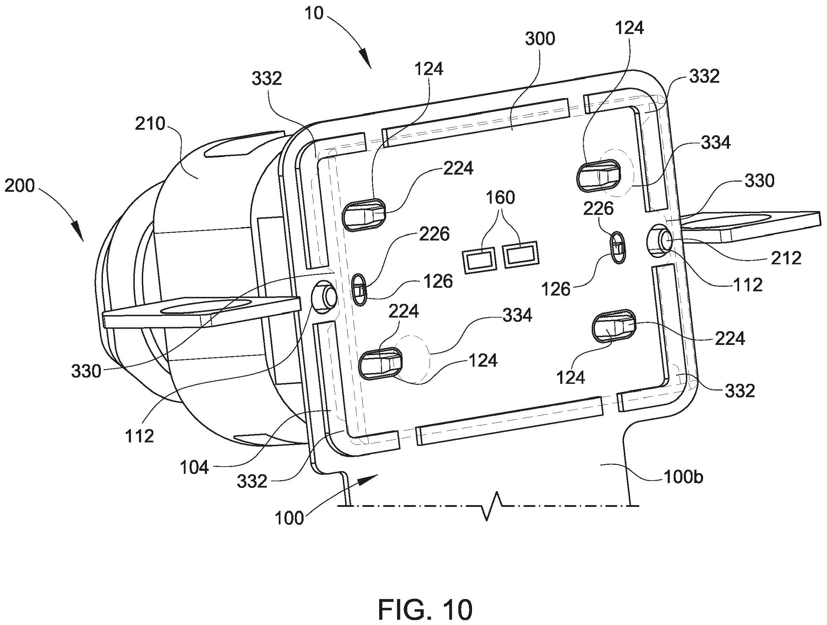

The FPC 100 and connections between the FPC 100 and the USB-C connector 200 will now be described with reference to Figures 8 to 10. Figure 8 is a partial rear perspective view of the FPC assembly 10, and shows components on the front surface 100a and the rear surface 100b of the FPC 100 under the shield can 300. Figure 9 is a partial rear view of the FPC assembly 10, and shows the components on the front surface 100a and the rear surface 100b of the FPC 100. Figure 10 is a partial rear perspective view of the FPC assembly 10 showing the components on the rear surface of the FPC 100.

Referring to Figures 8 and 9, the FPC 100 includes electrical contact pads ("contact pads") corresponding to the signal pins 220, and the ground fence pins 228. More specifically, the FPC 100 includes a plurality of signal pin contact pads 120 positionally corresponding to and configured to electrically interface with the plurality of signal pins 220 and a plurality of ground fence pin contact pads 128 positionally corresponding to and configured to electrically interface with the ground fence pins 228. The FPC 100 can also include power pin contact pads 142 positionally corresponding to and configured to electrically interface with the power pins 242.

The signal pin contact pads 120, the ground fence pin contact pads 128, and the power pin contact pads 142 are disposed on the front surface 100a of the FPC 100 in the connector mounting portion 102. For example, the signal pin contact pads 120, the ground fence pin contact pads 128, and the power pin contact pads 142 can be made of copper.

The FPC 100 can include a plurality of first through-holes 124 disposed in the connector mounting portion 102 and positionally corresponding to the plurality of first ground pins 224, and a pair of second through-holes 126 disposed in the connector mounting portion 102 and positionally corresponding to the pair of second ground pins 226. To ensure that the signal pins 120 are fully shielded on the front surface 100a of the FPC 100, first ground pin contact pads 125 can be disposed to surround the first through-holes 124 on the front surface 100a of the FPC 100 and ground pin contact pads 127 can be disposed to surround the second through-holes 126 on the front surface 100a of the FPC 100.

Referring to Figures 8 and 9, the signal pin contact pads 120 can be arranged in an array in central region of the connector mounting portion 102. The first through-holes 124, the second through-holes 126, the first ground pin contact pads 125, the second ground pin contact pads 127, and the ground fence pin contact pads 128 can be disposed in a pattern surrounding the signal pin contact pads 120. For example, the first through-holes 124, the second through holes 126, the first ground pin contact pads 125, the second ground pin contact pads 127, and the ground fence pin contact pads 128 can be arranged along a perimeter path surrounding the array of signal pins 220. For example, the first through-holes 124, the second through-holes 126, the first ground pin contact pads 125, the second ground pin contact pads 127, and the ground fence contact pads 128 can be arranged along a rectangular perimeter path surrounding the array of signal pins 220.

As shown in Figure 8, in some embodiments, the first through-holes 124 and first ground pin contact pads 125 can be disposed at corner positions A2, B2, C2, and D2, respectively, on a rectangular perimeter path surrounding the array of signal pin contact pads 120. One group of the ground fence pin contact pads 128 can be disposed outside of (above) the array of signal pin contact pads 120, and can be disposed in-line at positions E2 between the first through-holes 124/first ground pin contact pads 125 at the corner positions A2 and B2, along the rectangular perimeter path surrounding the array of signal pin contact pads 120. Another group of the ground fence pin contact pads 128 can be disposed outside of (below) the array of signal pin contact pads 120, and can disposed in-line at positions F2 between first through-holes 124/first ground pin contact pads at the corner positions C2 and D2, along the rectangular perimeter path surrounding the array of signal pin contact pads 120. One of the second through-holes 126/second ground pin contact pads 127 can be disposed laterally outside of the array of signal pin contact pads 120, and can be disposed at position G2 between the first through-holes 124/first ground pin contact pads 125 at the corner positions A1 and C1. Another one of second through-holes 126/second ground pin contact pads 127 can be disposed laterally outside of the array of signal pin contact pads 120, and can be disposed at position H2 between first through-holes 124/first ground pin contact pads 127 at the corner positions B2 and D2. The positions A2, B2, C2, D2, E2, F2, G2, and H2 on the front surface 100a of the FPC 100 correspond to the positions A1, B1, C1, D1, E1, F1, G1, and H1 on the USB-C connector 200.

Thus, the first and second through-holes 124 and 126 are arranged in a first column from position A2 to position C2 and a second column from position B2 to position D2, and the ground fence pin contact pads 128 are arranged in first row between the first and second columns and a second row between the first and second columns. The signal pin pads 120 are disposed between the first and second columns and the first and second rows.

Still referring to Figure 8, the power pin contact pads 142 can be respectively disposed outside of (above) the group of ground fence pin contact pads 128 at positions E2 and outside of (below) the group of ground fence pin contact pads 128 at positions F2.

The FPC 100 can further include third through-holes 112 disposed laterally outside of the first and second ground pin contact pads 124 and 126, respectively. The third through holes 112 positionally correspond to the alignment pins 212 of the connector body 210.

As shown in Figure 8, the USB-connector 200 interfaces with the FPC 100 at positions A2, B2, C2, D2, E2, F2, G2, H2, I2, and J2. More specifically, the signal pins 220 are soldered to the respective signal pin contact pads 120 on the front surface 100a of the FPC 100, the ground fence pins 228 are soldered to the respective ground fence pin contact pads 128 at the positions E2 and F2 on the front surface 100a of the FPC 100, and the power pins 242 are soldered to the respective power pin contact pads 142. As shown in Figures 7 and 9, the first ground pins 224 are inserted through the respective first through-holes 124 at the positions A2, B2, C2, and D2 and extend from the front surface 100a of the FPC 100 through the rear surface 100b of the FPC 100. The second ground pins 226 extend through the respective second through-holes 126 at the positions G2 and H2 and extend from the front surface 100a of the FPC 100 through the rear surface 100b of the FPC 100. The first and second ground pins 224 and 226 are soldered to the first and second ground pin contact pads 125 and 127, respectively, on the FPC 100 and in the first and second through holes 124 and 126, respectively to form robust electrical and structural connections between the USB-C connector 200 and the FPC 100.

The solder joints of the signal pins 220 and the ground fence pins 228, and other pins mounted on the front surface 100a of the FPC 100 can have a thickness of about 0.13 mm. That is, solder paste can be applied to the pins on the front surface 100a using a 0.13 mm-thick stencil to account for connector coplanarity. The solder joints of the first and second ground pins 224 and 226, and other pins mounted on the rear surface 100b of the FPC 100 can have a thickness of about 0.08 mm. That is, solder paste can be applied to the pins on the rear surface 100b using a 0.08 mm-thick stencil.

Referring to Figures 8 and 9, the first ground pins 224, the second ground pins 226, the first through-holes 124, the second through holes 126, and the ground fence pins 228, are disposed in a perimeter path surrounding the signal pins 120 on the front surface 100a of the FPC 100. Thus, by being electrically connected to the various contact pads described above, the first ground pins 224, the second ground pins 226, the first through-holes 124, the second through holes 126, and the ground fence pins 228 form a shielding barrier electrically shielding the signal pins 120. For example, the shielding barrier can be rectangular in shape.

To ensure effective shielding of the signal pins 120, the spacing between any two adjacent grounding features (e.g., the first ground pins 224, the second ground 226, and the ground fence pins 228) must be within a prescribed distance. The maximum allowable distance between adjacent grounding features 224/226/228 is determined based on the wavelength A of signals transmitted and received by the device in which the FPC assembly 10 is installed. In some embodiments, a maximum allowable distance between any two adjacent grounding features 224/226/228 can be λ × 10.

The alignment pins 212 extend through the respective second through-holes 112 at the positions I2 and J2 and extend from the front surface 100a of the FPC 100 through the rear surface 100b of the FPC 100. The alignment pins 212 are inserted into the respective second through-holes 112 during assembly of the FPC assembly 10 to properly align the USB-C connector 200 on the FPC 100. The alignment pins 212 can be bonded to the FPC 100 by adhesive, for example. Alternatively, the alignment pins can be inserted in the respective through-holes 112 without being bonded to the FPC 100.

Referring to Figure 10 again, electrostatic discharge (ESD) protection components including one or more ESD diodes 160 can be mounted on the rear surface 100b of the FPC 100 to protect other circuits in the FPC assembly 10 from high-voltage ESD entering the USB-C connector 200.

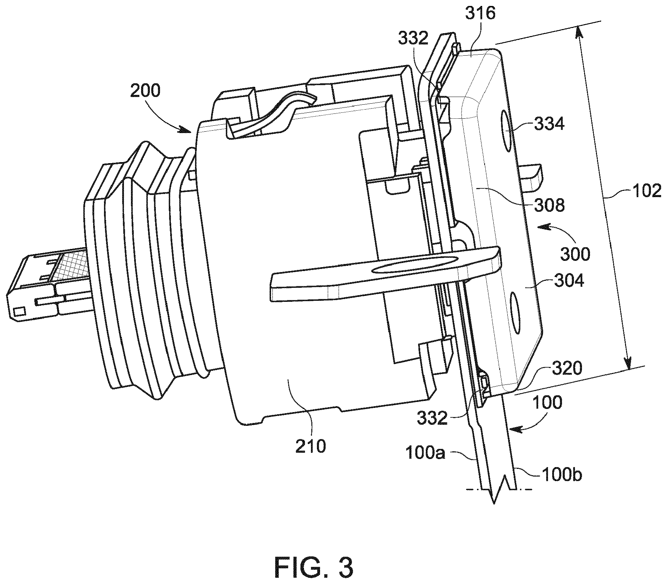

The shield can 300 will now be described with reference to Figures 3 to 5, 7, and 10.

As shown in Figures 3 to 5, 7, and 10, the shield can 300 is a pan-shaped member. The shield can 300 has a back wall 304, lateral sidewalls 308 and 312, an upper sidewall 316, and a lower sidewall 320. In some embodiments, the back wall 304, the lateral sidewalls 308 and 312, the upper sidewall 316, and the lower sidewall 320 can have rectangular shapes. However, the shield can 300 can have other shapes. The shield can 300 is made of a conductive material. For example, the shield can 300 can be made of tin-plated steel or nickel aluminum, but can be made of other materials suitable for electromagnetic field (EMF) shielding.

Referring to Figure 10, the shield can 300 is mounted on the rear surface 100b of the FPC 100 in the connector mounting portion 102. For example the shield can 300 can be soldered or bonded to a pad 104 disposed on the rear surface 100b of the FPC 100.

The shield can 300 stiffens the area it overlaps on the FPC 100. Thus, the shield can 300 functions as a strain relief and thereby prevents breakage of solder connections in the area it overlaps when the FPC 100 bends or flexes. In some embodiments, the shield can 300 overlaps an entirety of an area occupied by the signal pins 220, the first and second ground pins 224 and 226, the ground fence pins 228, and the power pins 242 and thereby provides maximum protection of the solder joints of these components. More specifically, for example, the shield can 300 can surround an area on the rear surface 100b of the FPC 100 that overlaps an entirety of an area occupied by the signal pins 220, the first and second ground pins 224 and 226, the ground fence pins 228, and the power pins 242.

As shown in Figures 3, 4, 7, and 10 in some embodiments, the lateral sidewalls 308 and 312 of the shield can 300 can be respectively aligned with the alignment pins 212 and can include cut-out portions 330 accommodating the alignment pins 212. This configuration prevents the location of the alignment pins 212 from limiting the size of the shield can 300, so that the area on the FPC overlapped by the shield can 300 can be maximized.

Additionally, as shown in Figures 3-5, 7, and 10, cut-out portions 332 can be formed at each of a corner between the lateral sidewall 308 and the upper sidewall 316, a corner between the lateral sidewall 308 and the lower sidewall 320, a corner between the lateral sidewall 312 and the upper sidewall 316, and a corner between the lateral sidewall 312 and the lower sidewall 320.

Additionally, holes 334 can be formed in the back wall 304.

To ensure effective EMF shielding, the number, location, and size of cut-out portions and holes in the shield can 300 can be determined based on the wavelength λ. For example, an acceptable aperture size of the cut-out portions 330, 332, and 334 can be λ/20 to λ/50. For signal frequencies up to 7 GHz, a target aperture size of the cut-out portions 330, 332, and 334 can be 1 mm, and a maximum aperture size can be 2 mm.

Referring to Figure 10, ESD protection components including at least the one or more ESD diodes 160 can be mounted on the rear surface 100b of the FPC, under the shield can 300. For example, the one or more ESD diodes 160 can be soldered on the rear surface 100b using a 0.08 mm-thick stencil, and can have a thickness of about 0.08 mm.

Thus, the shield can 300 provides a strain-relieved portion of the FPC 100 while also covering the ESD protection components and performing EMF shielding of the ESD protection components and the additional electrical components mounted in the connector mounting portion 102 of the FPC.

Further, by enabling the ESD protection components and potentially other components to be mounted under the shield can 300 in a location directly behind (e.g., overlapping) the USB-C connector 200, the shield can 300 provides the aforementioned benefits while increasing the usable surface area of the FPC 100 for placing components. This is advantageous for current future generations of consumer electronics, as demands for miniaturization and weight reduction of electronic components and devices increase.

Further still, mounting the ESD protection components under the shield can 300 locates the ESD protection components as close as possible to the ESD inflow location, and improves the mitigation performance of the ESD protection components.

According to embodiments disclosed herein, a flexible printed circuit board (FPC) assembly including an FPC, an electrical connector mounted on the FPC and configured to transfer data and power signals, and a shield can mounted on the FPC in alignment with the electrical connector. In some embodiments, the electrical connector can be a USB-C connector. The electrical connector can be mounted on a first side of the FPC, and can include a plurality of electrical connection components that are electrically connected to the FPC.

The electrical connection components can include a plurality of signal pins and a plurality of ground pins. The plurality of ground pins can be disposed in a perimeter path surrounding the plurality of signal pins. In some embodiments, some of the ground pins can be surface-mounted on the first side of FPC, and some of the ground pins can be through-hole mounted in the FPC such that they extend through a second surface of the FPC opposite the first surface of the FPC. Thus, the electrical connector can be securely mounted to the FPC such that the electrical connector is resistant to twisting and tilting with respect to the FPC.

The shield can can be mounted on the second surface of the FPC in alignment with electrical connector. The shield can can stiffen the FPC and function as a strain-relief. In some embodiments, the shield can can overlap an entire area occupied by the electrical connection elements of the electrical connector that are mounted on the FPC. Thus, the shield can is able to prevent solder joints of all of the electrical connection elements of the electrical connector from breaking when the FPC bends and flexes.

Additionally, the shield can can electromagnetically shield electrical components of the FPC assembly. In some embodiments, electrostatic discharge (ESD) protection components, such as ESD diodes, can be mounted on the second surface of the FPC at locations overlapping the electrical connector, and the shield can can cover the ESD protection components. The shield can is therefore able to electromagnetically shield the ESD protection components.

Because the shield can can be mounted on the FPC directly behind the electrical connector and provides a space within the shield can to mount additional electrical components on the FPC, the shield can is able to implement a stiffening/strain-relief function without reducing available space for mounting electrical components on other portions of the FPC. For example, the ESD protection components can be mounted in the area within the shield can instead of on other portions of the FPC, thereby freeing up the other portions of the FPC to have other components mounted thereon and/or enabling the size of the FPC to be reduced. Therefore, an FPC assembly according to embodiments disclosed herein is advantageous for current and future generations of consumer electronics, as demands for miniaturization and weight reduction of electronic components and devices increase

In addition to increasing space-efficiency of the FPC, mounting the ESD protection components within the shield can, directly behind the electrical connector, locates the ESD protection components as close as possible to the ESD inflow location, and therefore improves the mitigation performance of the ESD protection components.

Reference in this specification to "embodiments" (e.g., "some embodiments," "various embodiments," "one embodiment," "an embodiment," etc.) means that a particular feature, structure, or characteristic described in connection with the embodiment is included in at least one embodiment of the disclosure. The appearances of these phrases in various places in the specification are not necessarily all referring to the same embodiment, nor are separate or alternative embodiments mutually exclusive of other embodiments. Moreover, various features are described which may be exhibited by some embodiments and not by others. Similarly, various requirements are described which may be requirements for some embodiments but not for other embodiments.

As used herein, the word "or" refers to any possible permutation of a set of items. For example, the phrase "A, B, or C" refers to at least one of A, B, C, or any combination thereof, such as any of: A; B; C; A and B; A and C; B and C; A, B, and C; or multiple of any item such as A and A; B, B, and C; A, A, B, C, and C; etc.

Throughout the specification, when an element, such as a layer, region, or substrate, is described as being "on," "connected to," or "coupled to" another element, it may be directly "on," "connected to," or "coupled to" the other element, or there may be one or more other elements intervening therebetween. In contrast, when an element is described as being "directly on," "directly connected to," or "directly coupled to" another element, there can be no other elements intervening therebetween.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

Spatially relative terms such as "above," "upper," "below," and "lower" may be used herein for ease of description to describe one element's relationship to another element as shown in the figures. Such spatially relative terms are intended to encompass different orientations of the device in use or operation in addition to the orientation depicted in the figures. For example, if the device in the figures is turned over, an element described as being "above" or "upper" relative to another element will then be "below" or "lower" relative to the other element. Thus, the term "above" encompasses both the above and below orientations depending on the spatial orientation of the device. The device may also be oriented in other ways (for example, rotated 90 degrees or at other orientations), and the spatially relative terms used herein are to be interpreted accordingly.

The terminology used herein is for describing various examples only, and is not to be used to limit the disclosure. The articles "a," "an," and "the" are intended to include the plural forms as well, unless the context clearly indicates otherwise. The terms "includes" and "has" specify the presence of stated features, numbers, operations, members, elements, and/or combinations thereof, but do not preclude the presence or addition of one or more other features, numbers, operations, members, elements, and/or combinations thereof.

Due to manufacturing techniques and/or tolerances, variations of the shapes shown in the drawings may occur. Thus, the examples described herein are not limited to the specific shapes shown in the drawings, but include changes in shape that occur during manufacturing.

Although the subject matter has been described in language specific to structural features and/or methodological acts, it is to be understood that the subject matter defined in the appended claims is not necessarily limited to the specific features or acts described above. Specific embodiments have been described herein for purposes of illustration, but various modifications can be made without deviating from the scope of the embodiments. The specific features and acts described above are disclosed as example forms of implementing the claims that follow. Accordingly, the embodiments are not limited except as by the appended claims.

Aspects can be modified, if necessary, to employ the systems, functions, and concepts of the various references described above to provide yet further embodiments. If statements or subject matter in a document noted above conflicts with statements or subject matter of this application, then this application shall control.

## Claims

1. A flexible printed circuit board (FPC) assembly, comprising:
an FPC having a front surface and a rear surface;
a USB-C connector mounted on the front surface of a first portion of the FPC, the USB-C connector having a plurality of electrical connection elements extending from an end of the USB-C connector and electrically connected to the FPC;
one or more electrostatic discharge (ESD) protection components mounted on the rear surface of a second portion of the FPC, wherein the first portion, with the front surface on which the USB-C connector is mounted, overlaps with the second portion, with the rear surface on which the one or more electrostatic discharge (ESD) protection components are mounted; and
a shield can mounted on the rear surface of the FPC and covering at least some of the one or more ESD components.

2. The FPC assembly of claim 1, wherein the plurality of electrical connection elements includes:
a plurality of signal pins; and
a plurality of grounding components surrounding the plurality of signal pins,
wherein the rear surface of a portion of the FPC covered by the shield can overlaps with an entirety of the front surface of a portion of the FPC occupied by the plurality of electrical connection elements;
optionally, wherein the plurality of grounding components includes:
through-hole mounted ground pins arranged in a first and second columns outside of the signal pins, the through-hole mounted ground pins extending from the front surface of the FPC through the rear surface of the FPC; and
surface-mounted ground pins arranged in first and second rows extending between the first and second columns, the surface-mounted ground pins being surface mounted on the front surface of the FPC, and
wherein the plurality of signal pins are disposed between the first and second columns and between the first and second rows.

3. The FPC assembly of claim 2, wherein the plurality of electrical connection elements further include power pins disposed outside of the plurality of grounding components; optionally, wherein the power pins are configured to be connected to contact charging components.

4. The FPC assembly of claim 2 or claim 3, wherein the USB-C connector further includes alignment pins through-hole mounted in the FPC at positions outside of the plurality of grounding components so as to extend from the front surface of the FPC and through the rear surface of the FPC, and wherein sidewalls of the shield can include cut-out portions accommodating the alignment pins.

5. The FPC assembly of any preceding claim, wherein sidewalls of the shield can include cut-out portions and a back wall of the shield can includes apertures.

6. A flexible printed circuit board (FPC) assembly, comprising:
an FPC having a first surface and a second surface opposite the first surface;
an electrical connector mounted on the first surface of a connector mounting portion of the FPC and configured to transfer data and power signals; and
a shield can mounted on the second surface of a shield can mounting portion of the FPC,
wherein the shield can mounting portion, with the second surface on which the shield can is mounted, overlaps with the connector mounting portion, with the first surface on which the electrical connector is mounted.

7. The FPC assembly of claim 6, further comprising:
one or more electrostatic discharge (ESD) protection components mounted on the second surface of the shield can mounting portion,
wherein the shield can covers the one or more ESD protection components.

8. The FPC assembly of claim 7, wherein the electrical connector includes:
a plurality of signal pins electrically connected to the FPC on the first surface of the connector mounting portion; and
a plurality of grounding components disposed around the plurality of signal pins and electrically connected to the FPC on the first surface of the connector mounting portion,
wherein the shield can mounting portion, with the second surface on which the shield can is mounted, overlaps with an entirety of the connector mounting portion, with the first surface on which the plurality of signal pins and the plurality of grounding components are mounted.

9. The FPC assembly of claim 8,
wherein the plurality of grounding components is disposed in a perimeter path on the first surface of the connector mounting portion, the perimeter path surrounding the plurality of signal pins, and
wherein the plurality of grounding components include:
a first ground pin disposed at a first corner position on the perimeter path;
a second ground pin disposed at a second corner position on the perimeter path;
a third ground pin disposed at a third corner position on the perimeter path;
a fourth ground pin disposed at a fourth corner position on the perimeter path;
a first group of ground fence pins disposed on the perimeter path at locations between the first and second ground pins;
a second group of ground fence pins disposed on the perimeter path at locations between the third and fourth ground pins;
a fifth ground pin disposed on the perimeter path between the first and third ground pins; and
a sixth ground pin disposed on the perimeter path between the second and fourth ground pins;
optionally, wherein the first, second, third, fourth, fifth, and sixth ground pins are through-hole solder-mounted so as to extend from the first surface of the FPC to the second surface of the FPC.

10. The FPC assembly of claim 8 or claim 9, wherein the electrical connector further includes power pins mounted on the first surface of the connector mounting portion, outside of the plurality of grounding components, and wherein the shield can mounting portion, with the second surface on which the shield can is mounted, overlaps with an entirety of the connector mounting portion, with the first surface on which the plurality of signal pins, the plurality of grounding components, and the power pins are mounted.

11. The FPC assembly of any one of claims 8 to 10,
wherein the electrical connector further includes alignment pins through-hole mounted in the FPC at positions outside of the plurality of grounding components so as to extend from the first surface of the FPC and through the second surface of the FPC, and
wherein sidewalls of the shield can include cut-out portions accommodating the alignment pins.

12. A flexible printed circuit board (FPC) assembly, comprising:
an FPC having a front surface and a rear surface;
a USB-C connector mounted on the front surface of a first portion of the FPC, the USB-C connector having a plurality of electrical connection elements extending from an end of the USB-C connector and electrically connected to the FPC; and
a shield can mounted on the rear surface of a second portion of the FPC in alignment with the first portion, with the front surface on which the USB-C connector is mounted,
wherein the shield can is configured as a strain-relief.

13. The FPC assembly of claim 12, further comprising at least one electrostatic discharge (ESD) diode mounted on the rear surface of the second portion of the FPC,
wherein the shield can covers the ESD diode.

14. The FPC assembly of claim 12 or claim 13, wherein the electrical connection elements include:
a plurality of signal pins disposed on the front surface of the first portion; and
a plurality of grounding components disposed in a perimeter path on the front surface of the first portion, the perimeter path surrounding the plurality of signal pins, wherein the second portion, with the rear surface on which the shield can is mounted, overlaps with an entirety of the first portion, with the front surface on which the plurality of signal pins and the plurality of grounding components are mounted;
optionally, wherein the plurality of grounding components includes grounding pins that are mounted in through holes in the FPC;
optionally, wherein the electrical connection elements further include power pins of a contact charging assembly.

15. The FPC assembly of claim 14,
wherein a distance between adjacent grounding components among the grounding components is less than λ × 10, and
wherein λ is a wavelength of signals transmitted and received by a device in which the FPC assembly is installed.
